# EUROPÄISCHE PATENTSCHRIFT

(11) **EP 0 689 700 B1**
(45) Veröffentlichungstag und Bekanntmachung des Hinweises auf die Patenterteilung: **11.06.1997**
(21) Anmeldenummer: 94908977.5
(22) Anmeldetag: 14.03.1994
(51) Int. Cl.: G06K 7/10

(54) **VERFAHREN ZUR AUFNAHME VON STRICHCODIERUNGEN**
IMAGING PROCESS FOR BAR CODES
PROCEDE D'ACQUISITION DE CODES A BARRES

(30) Priorität: 18.03.1993 DE 4308699
(43) Veröffentlichungstag der Anmeldung: 03.01.1996
(73) Patentinhaber: SIEMENS AKTIENGESELLSCHAFT, 80333 München (DE)
(72) Erfinder: FROESE-PEECK, Rüdiger, D-81379 München (DE); GERHARD, Detlef, D-81739 München (DE); LECHNER, Johann, D-80798 München (DE)
(86) Internationale Anmeldenummer: DE9400278
(87) Internationale Veröffentlichungsnummer: WO9422104

(56) Entgegenhaltungen:
- WO-A-86/03605
- DE-A- 4 114 925
- FR-A- 2 594 982
- FR-A- 2 652 914

## Beschreibung

Die Erfindung betrifft ein Verfahren zum Beleuchten von flächigen Strichcodierungen, wobei zur Erkennung und Auswertung der Strichcodierung über eine Empfängeroptik auf einem Empfangssensor ein Bild der Strichcodierung erzeugt wird. Die Beleuchtung und der Empfangssensor sind an die üblicherweise längs gestreckte flächige Form einer Strichcodierung angepaßt. Das Verfahren ist zum Einsatz in einem Barcode-Lesegerät geeignet.

In der Halbleiterfertigung werden auf Siliziumscheiben (Wafer) mit unterschiedlichen chemischen und physikalischen Prozessen Halbleiterstrukturen aufgebaut (elektronische Bauelemente; Chips). Die Wafer müssen während der gesamten Chip-Fertigung immer eindeutig einem Fertigungsauftrag zuzuordnen sein. Nur so läßt sich für die Wafer der nächste Prozeßschritt sicher bestimmen und die anfallenden Prozeßdaten können gespeichert werden. Zur eindeutigen Identifizierung verschiedener Wafer wird auf diesen eine Markierung aufgebracht. Zum Markieren können in vorteilhafter Weise Laserverfahren eingesetzt werden. Hierbei wird auf einen Wafer entweder eine sog. Klarschrift und/oder eine Strichcodemarkierung aufgebracht. Aufgrund der Vielzahl von nachfolgenden Prozeßschritten, bei denen Materialbeschichtungen, Ätzfolgen oder ähnliches auf dem Wafer ablaufen, wird die Markierung in Mitleidenschaft gezogen. Die Markierungsqualität nimmt im Mittel mit der Anzahl der Fertigungsschritte ab.

Soll die Prozeßführung mit dem Einsatz von automatischen Identifikationseinrichtungen unterstützt werden, so müssen auch Markierungen mit schlechter Qualität sicher identifizierbar sein.

Die Identifizierung von Wafern erweist sich wegen der vorhandenen Störgrößen und der durchzuführenden Bearbeitungsprozesse, die die Markierungen in Mitleidenschaft ziehen, als sehr schwierig. Die Identifikation wird deshalb oft von Menschen durchgeführt. Vereinzelt werden auch intelligente Bildverarbeitungssysteme oder speziell auf dieses Problem abgestimmte Scanner zur Barcode-Erkennung verwendet. Auftretende Störgrößen wie beispielsweise ungenaue Waferzuführung, Verkippung des Wafers und Schlieren auf der Markierung oder zu geringe Kontraste innerhalb der Strichcodierung führen zu einer verminderten Betriebssicherheit der Identifikationssysteme. Die Erkennung der Markierung mit dem menschlichen Auge ist kosten- und zeitintensiv. Der Einsatz von Bildverarbeitungssystemen ist ebenfalls kostspielig und nicht ausreichend sicher. Die Erkennungszeiten liegen in der Regel über einer Sekunde.

In der deutschen Patentschrift DE 27 04 983 C3 wird eine Vorrichtung beschrieben, mit der das gesamte Gesichtsfeld, beispielsweise das Feld der Markierungsfläche einer Strichcodierung, auf die wirksame Fläche einer als Empfangssensor eingesetzten Fotodiodenzeile abgebildet wird. Die Vorrichtung dient jedoch zum Erkennen von Fehlern in der Oberfläche oder in den Abmessungen eines Objektes.

Weiterhin werden in den beiden französischen Patentanmelduungen FR-A-2 652 914 und FR-A-2 594 982 jeweils Leseeinrichtungen für Strichcodierungen beschrieben. In beiden Druckschriften wird das zu lesende Objekt derart beleuchtet, daß maximale Kontraste zwischen Markierungen und umgebenden Flächen erzeugt werden. Dabei wird im wesentlichen auf eine vollständige und optimale Ausleuchtung durch entsprechende Anordnung von Lichtquelle und Empfänger abgestellt.

Der Erfindung liegt die Aufgabe zugrunde, innerhalb des auf einem Empfangssensor erzeugten Bildes einer auf einer spiegelnden Oberfläche angebrachten Strichcodierung optimale Kontraste zu erzielen, um die Lage von Markierungselementen innerhalb der Strichcodierung eindeutig zu detektieren. Die Lösung dieser Aufgabe geschieht durch den Gegenstand der Ansprüche 1 oder 2.

Der Erfindung liegt die Erkenntnis zugrunde, daß bei der Abbildung einer auf einer spiegelnden Oberfläche aufgebrachten Strichcodierung auf einen zumindest eindimensional auflösenden Empfangssensor, beispielsweise eine Photodiodenzeile, ein, möglichst kontrastreiches Bild erzeugt werden muß. Diesbezüglich wird die Beleuchtung der Strichcodierung so angeordnet, daß das Licht von der spiegelnden Oberfläche in die Empfangsoptik reflektiert wird, so daß eine Hellfeldbeleuchtung entsteht. In dem Bild der Strichcodierung auf der Fotodiodenzeile sind die Markierungselemente, die Striche, somit als dunkle Bereiche und die Zwischenräume als helle Bereiche zu erkennen. Ebenso kann eine Dunkelfeldbeleuchtung erzeugt werden. In diesem Fall wird in dem Bild der Strichcodierung auf der Photodiodenzeile ein Markierungselement, ein Strich, somit als heller Bereich und ein Zwischenraum zwischen den Markierungselementen als dunkler Bereich erscheinen. Die Einstellung der Hellfeldbeleuchtung bzw. der Dunkelfeldbeleuchtung bei spiegelnden Objekten in Kombination mit einer längs gestreckten Strichcodierung erfordert den Einsatz einer Lichtzeile, deren Lage veränderbar bzw. einstellbar sein muß. Es ist sicherzustellen, daß von jedem Teil der Markierungsfläche der Strichcodierung Lichtstrahlen in die Empfängeroptik gelangen. Kontraste auf einer spiegelnden Oberfläche kommen durch die unterschiedlichen Rauhigkeiten zustande. Die Markierungsfläche einer Strichcodierung weist Markierungselemente und Zwischenräume bzw. umliegende Markierungsflächen auf. Dabei sind die Markierungselemente aktiv, beispielsweise über ein Laserverfahren, aufgetragen worden und ihre Oberfläche ist rauher. Die Rauhigkeiten bewirken eine Streuung des von den Markierungselementen reflektierten Lichtes.

Die hierbei anzuwendende Auflichtbeleuchtung ist per Definition nach "Technische Optik; Prof. Gottfried Schröder; Vogel Buchverlag Würzburg; Seite 152" in Hellfeld- oder Dunkelfeldbeleuchtung unterscheidbar. Eine Hellfeldbeleuchtung liegt vor, wenn das undurchsichtige Objekt von oben beleuchtet wird und eine fehlerfreie Fläche ein gleichmäßig helles Sehfeld für den Empfänger des reflektierten Licht stromes bietet. Eine Dunkelfeldbeleuchtung liegt vor, wenn Beleuchtungsbündel nach der Reflektion auf der Oberfläche des Objektes nicht in den Empfänger einfallen. Bei fehlerfreier Oberfläche würde sich in diesem Fall ein gleichmäßig dunkles Sehfeld ergeben.

Der Erfindung liegt die Erkenntnis zugrunde, daß eine möglichst kontrastreiche Hellfeld- oder Dunkelfeldbeleuchtung erzielt werden muß. Die Grundlage für die Betrachtungen ist die Regel, daß der Einfallswinkel gleich dem Ausfallswinkel ist. Für die jeweils eingestellte Beleuchtungsart gilt es nun, die optimale Beleuchtungsstärke mit einem optimalen Kontrast am Empfangssensor einzustellen. Falls die Oberfläche des Objektes nicht einem idealen Spiegel entspricht, sondern das einfallende Licht durch Rauhigkeiten gestreut wird, wird die Lichtverteilung des reflektierten Lichtes in die Breite gezogen. Es fällt nicht jedes Lichtbündel, das reflektiert wird, in die Empfängeroptik. Zudem ist die Breite der Lichtzeile quer zu ihrer Längserstreckung derart auszubilden, daß Lichtanteile von auf der Strichcodierung gestreutem Licht, die ihren Ursprung in den Randbereichen der Lichtzeile haben und die in die Empfängeroptik gelangen, minimiert werden.

Eine vorteilhafte Ausgestaltung der Erfindung sieht vor, daß zur Erzeugung einer Lichtzeile das von Leuchtdioden der Beleuchtungseinrichtung ausgesandte Licht an einer Austrittsfläche homogenisiert ist und ein Teil dieses Lichtes über eine nachgeschaltete Spaltblende eine Lichtzeile darstellt. Wie oben beschrieben, ist die Spaltblende bewegbar, um in einer bestimmten Stellung eine Hellfeldbeleuchtung bzw. eine Dunkelfeldbeleuchtung zu erzielen.

Die Ausbildung einer diskreten Lichtzeile, die in z-Richtung bewegbar ist, läßt sich ebenfalls durch eine Beleuchtungseinrichtung entsprechend dem kennzeichnenden Teil des Anspruches 4 erzielen.

Durch den Einsatz einer speziellen Optik wird die Höhe der Markierungen einer Strichcodierung verkleinert bzw. integriert. Die beleuchtete und aufgenommene Höhe eines Markierungselementes bzw. aller Markierungselemente wird durch die Optik in einer Richtung, speziell in der z-Richtung, gestaucht, so daß die Abbildung auf dem positionsempfindlichen Empfänger derart ausgebildet ist, daß das Gesichtsfeld bzw. der beleuchtete Bereich der Strichcodierung in Hinsicht auf eine vollständige Auflösung vollständig abgebildet wird. Eine Auflösung zwischen den Markierungselementen und den diese umgebenden Markierungsflächen innerhalb der Strichcodierung geschieht in der Form, daß mindestens zwei bis drei Elemente des Sensors für einen möglichen Platz eines Markierungselementes bzw. der Abbildung des Markierungselementes auf dem Sensor zur Verfügung stehen.

Weitere vorteilhafte Ausgestaltungen der Erfindung können den Unteransprüchen entnommen werden.

Im folgenden werden anhand der schematischen Figuren das der Erfindung zugrunde liegende Prinzip und mehrerer Ausführungsbeispiele beschrieben.
- Fig. 1: stellt die Zusammenhänge bei der Bearbeitung von spiegelnden Oberflächen dar.
- Fig. 2a: stellt die optischen Zusammenhänge bezüglich des Kontrastes zwischen Markierungselementen und umliegender Markierungsfläche dar.
- Fig. 2b: erklärt die Kontrastreduzierung durch Lichtbündel von nebeneinander liegenden Beleuchtungselementen.

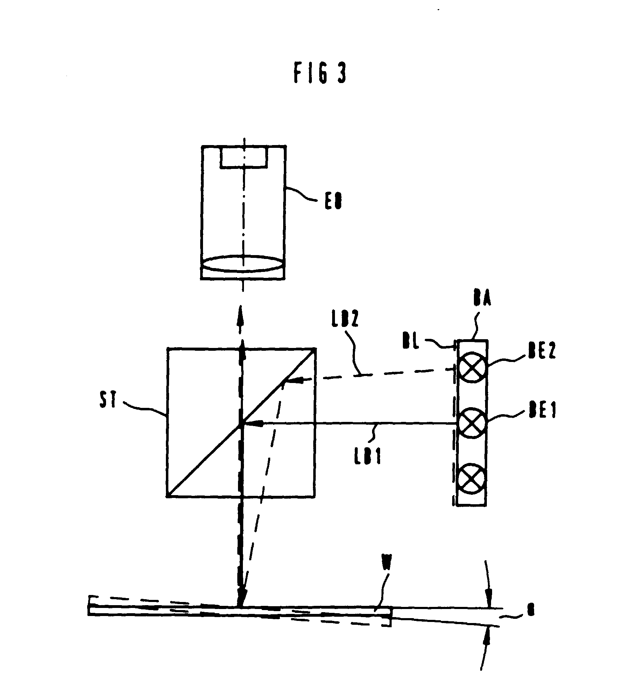

- Fig. 3: betrifft die Behandlung von verkippten Wafern.
- Fig. 4: stellt eine Gesamtanordnung der einzelnen Komponenten zur Aufnahme einer Strichcodierung dar.
- Fig. 5: betrifft eine Anordnung, die mittels eines Linsensystemes eine Beleuchtung mit gerichtetem Licht erzeugt.
- Fig. 6: ist eine Prinzipdarstellung der Gesamtanordnung, wobei die Strichcodierung auf einem verkippten Wafer zu lesen ist,
- Fig. 7: und 8 zeigen Darstellungen aus denen der Einfluß einer Verdrehung oder einer Verkippung eines Wafers zu entnehmen ist.

Das die Erfindung betreffende Verfahren löst die folgenden Probleme:
- Erkennung von Strichcodierungen auf spiegelnden Oberflächen,
- Auflösung bzw. Erkennung trotz geringem Kontrast zwischen Spiegel und Streufläche,
- Der Einfluß von Störgrößen wie beispielsweise Verkippung, Schlierenbildung, Kratzer, unterschiedliche Rauhigkeiten auf der Oberfläche, wird vermindert.

Das gesamte Verfahren nutzt eine spezielle Hellfeldbeleuchtung zum Abbilden der Markierungsfläche MF in eine Optik. Die Markierungselemente ME auf der Markierungsfläche MF streuen das auf ihnen auffallende Licht größenteils an der Empfängeroptik EO vorbei. Das Element erscheint dunkel.

Das System von Empfängeroptik EO und Empfängersensor ES bzw. Sensorfeld bildet die Markierung so ab, daß die verschiedenen Achsen der Abbildungsebenen unterschiedliche optische Maßstäbe aufweisen. Das System ist so ausgelegt, daß kleinste Flächenelemente entlang einer Achse auf dem Sensor integriert werden. Die Empfängeroptik EO bildet dabei insbesondere die Höhe der Striche einer Strichcodierung so ab, daß sie im Bild in ihrer Höhe gestaucht erscheinen. Dies bewirkt eine Integration der Helligkeit über die Balkenhöhe. Aus diesem Grund fallen kleine Fehler im Kontrast, beispielsweise das Fehlen eines Teiles einer Markierung oder ein Kratzer im weißen Zwischenraum, der schwarz erscheint, weniger stark auf. Dies führt insgesamt zu einer Reduzierung der störenden Auswirkungen der stochastisch auftretenden Störgrößen wie Kratzer oder Schlieren. Zusätzlich werden Inhomogenitäten der Markierungselemente ausgeglichen.

Störungen wie Waferverkippung oder unterschiedliche Rauhigkeiten der Oberfläche werden durch eine Nachregelung der Beleuchtungseinheit reduziert und der Kontrast wird verstärkt.

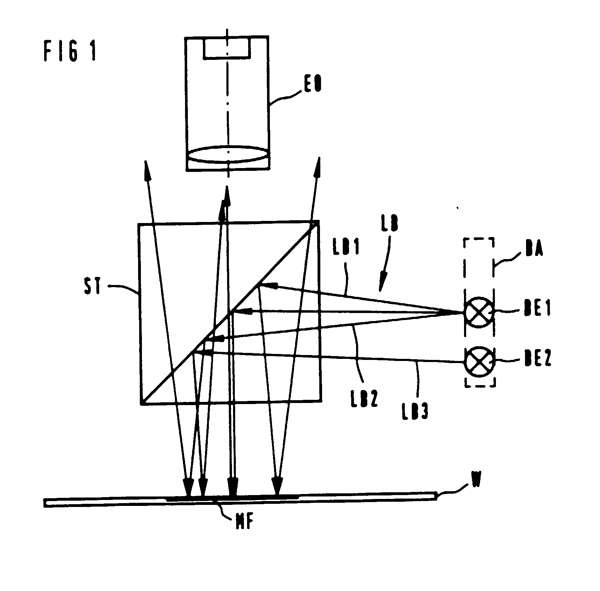

Die in Fig. 1 wegen der ebenen und spiegelnden Oberfläche dargestellte spezielle Beleuchtungsanordnung BA wird verwendet, um von jedem Teil der räumlich ausgedehnten Markierungfläche MF Lichtstrahlen in die Empfängeroptik EO gelangen zu lassen. Von jedem Beleuchtungselement BE, BE1-2 gelangt nur ein schmales Lichtbündel LB über den halbdurchlässigen Strahlteiler ST auf den Wafer W mit der Markierungsfläche MF und wird von hier in die Empfängeroptik EO reflektiert. Die Lichtbündel LB1 und LB2 des Beleuchtungselementes BE1 gelangen nicht in die Empfängeroptik EO. Mit vielen derartigen und richtig angeordneten Beleuchtungselementen kann die räumlich ausgedehnte Markierungsfläche MF gleichmäßig im Hellfeldverfahren ausgeleuchtet werden.

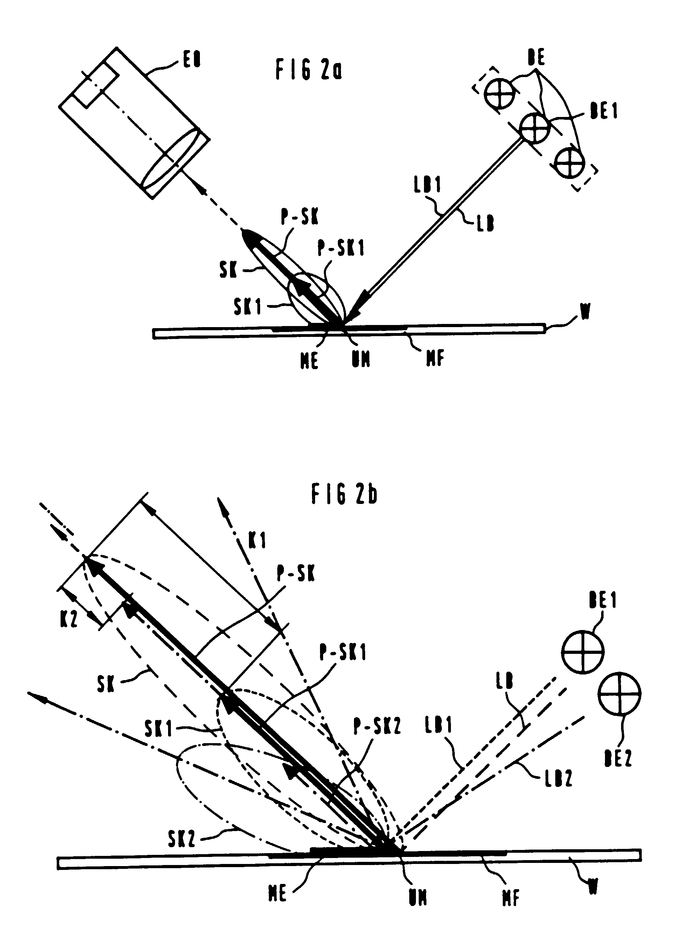

Bei einer üblichen Beleuchtungsanordnung BA liegen viele Beleuchtungselemente BE nebeneinander, wie in Fig. 2a dargestellt. Das Lichtbündel LB von dem Beleuchtungselement BE1 trifft auf die umliegende Markierungsfläche UM des Wafers W und wird in die Empfängeroptik EO reflektiert. Da die umliegende Markierungsfläche UM keine ideal spiegelnde Oberfläche darstellt, bildet das reflektierte Licht einen schmalen Streukegel SK aus. Die Lichtstrahlen mit der größten Intensität gelangen in die Empfängeroptik und sind als Pfeil P-SK dargestellt. Ein Lichtbündel LB1 trifft neben dem Lichtbündel LB auf ein Markierungselement ME und wird auch in die Empfängeroptik EO reflektiert. Da das Markierungselement ME eine höhere Rauhigkeit als die umliegende Markierungsfläche UM aufweist, bildet sich ein breiterer Streukegel SK1 aus. Der Pfeil P-SK1 stellt die größte Intensität dieses Streukegels durch seine entsprechende Länge dar. Auch das reflektierte Licht des Lichtbündels LB1 gelangt in die Empfängeroptik EO. Die Längendifferenz der Pfeile P-SK und P-SK1 gibt den Kontrast zwischen der umliegenden Markierungsfläche UM und dem Markierungselement ME wieder.

In Fig. 2b ist zusätzlich die Beleuchtung mit dem Beleuchtungselement BE2 dargestellt. Das Lichtbündel LB2 soll auf die gleiche Fläche des Markierungselementes ME wie das Lichtbündel LB1 auftreffen. Durch die Rauhigkeit des Markierungselementes ME bildet sich ein Streukegel SK2. Ein großer Teil des reflektierten Lichtes gelangt nicht in die Empfängeroptik EO. Aber ein Teil des reflektierten Lichtes, das durch den Pfeil P-SK2 dargestellt ist, weist die gleiche Richtung auf wie das Licht, das durch die Pfeile P-SK und P-SK1 repräsentiert wird, und gelangt auch in die Empfängeroptik EO.

Durch die Überlappung der reflektierten Lichtstrahlen der Lichtbündel LB, LB1, LB2 entsteht in der Empfängeroptik EO ein Bild des Wafers W mit dem geringsten Kontrast K2. Die Beleuchtungsanordnung ist so einzustellen, daß nur Licht vom Beleuchtungselement BE1 an der betreffenden Waferoberfläche auftrifft und damit der optimale Kontrast K1 in der Empfängeroptik erscheint.

Die Ebene der Markierungsfläche MF kann verkippt sein. Ebenso kann es durch Toleranzen bei der Waferzuführung zu einem Verkippen des Wafers W kommen. Für den Fall, daß der Wafer W in seiner Soll-Lage positioniert ist, wird entsprechend der oben beschriebenen Bedingungen nur das Beleuchtungselement BE1 der Beleuchtungsanordnung BA eingeschaltet. Mit der Blende BL wird angedeutet, daß nur ein schmales Lichtbündel LB1 über den Strahlteiler ST auf den Wafer W auftrifft. Das reflektierte Licht erzeugt in der Empfängeroptik EO ein kontrastreiches Bild bei Hellfeldbeleuchtung.

Wenn die Markierungsfläche MF unter dem Winkel a verkippt ist, muß ein Beleuchtungselement BE2 eingeschaltet werden, dessen Lichtbündel LB2 die Hellfeldbedingungen erfüllt, um ein kontrastreiches Bild zu erzeugen.

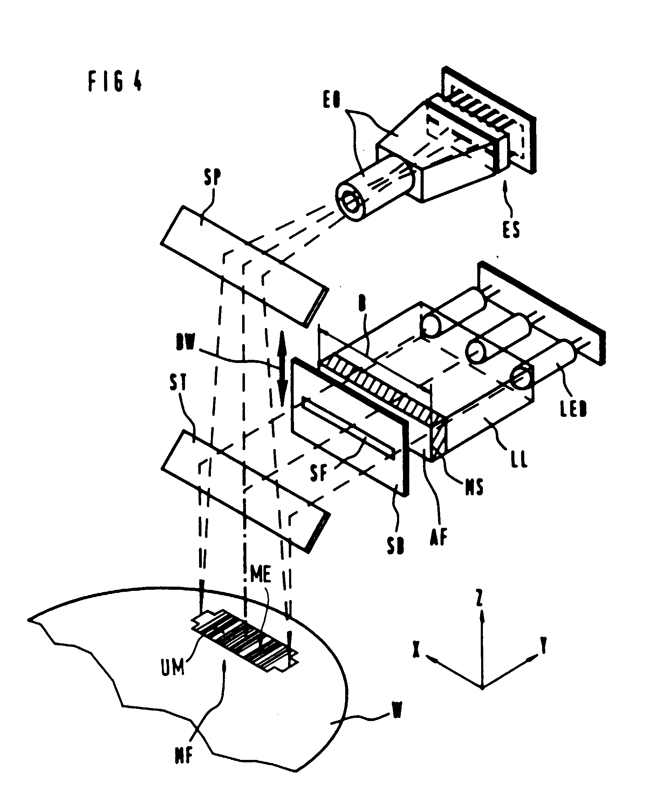

Die Figur 4 zeigt die Realisierung einer Anordnung zur Beleuchtung einer Strichcodierung auf einer spiegelnden Oberfläche. Die Beleuchtungseinrichtung enthält Leuchtdioden LED, die an einen Lichtleiter LL angekoppelt sind. Das an der Austrittsfläche AF des Lichtleiters bzw. einer zwischengeschalteten Mattscheibe MS austretende Licht ist weitestgehend homogen. Dies wird dadurch erreicht, daß das durch die Leuchtdioden LED in den Lichtleiter LL eingestrahlte Licht mehrfach an den Außenflächen des Lichtleiters LL reflektiert wird, wodurch die Homogenisierung des Lichtes herbeigeführt wird. Falls noch erforderlich, kann mit einer nachgeschalteten Mattscheibe MS zusätzlich eine Vergleichmäßigung des Lichtes über die Austrittsfläche erreicht werden.

Die Breite B der Lichtaustrittsfläche AF ist so gewählt, daß die beschriebenen Bedingungen zur Berücksichtigung der spiegelnden Oberfläche entsprechend Fig. 1 erfüllt sind. Die Breite B ist um ein entsprechendes Maß vergrößert, um bei einer Verkippung der Waferoberfläche um die y-Achse die beschriebene Bedingung weiterhin erfüllen zu können. Anfangs-und Endbereiche einer auf dem Wafer aufgebrachten Strichcodierung sind dann immer homogen ausgeleuchtet. In der Darstellung entsprechend Fig. 4 wird das Licht zunächst auf den Wafer W mit der Markierungsfläche MF geleitet, dort reflektiert und über den stationären Spiegel SP in die Empfängeroptik EO geführt. Die gesamte Anordnung berücksichtigt die in der Regel langgestreckte Rechteckform der Strichcodierung. Das über die Empfängeroptik EO auf dem Empfangssensor ES abgebildete Bild der Markierungsfläche MF ist bezüglich der Streckung in x-Richtung an die Elemente des in dieser Richtung ortsauflösenden Empfangssensor ES angepaßt. Liegt ein eindimensional auflösender Empfangssensor ES vor, so wird für jedes seiner Elemente ein integriertes bzw. gestauchtes oder komprimiertes Bild eines entsprechenden Ausschnittes der Markierungsfläche erzeugt. Durch diese integrierende Wirkung wird der Einfluß bestimmter Störgrößen, wie beispielsweise Kratzer oder Schlieren vermindert. Ein zweidimensional ortsauflösender Empfänger (CCD-Array) ist ebenso verwendbar.

Um die Bedingungen für einen optimalen Kontrast entsprechend der Fig. 2a und 2b zu erfüllen, wurde eine schmale Spaltblende SB angeordnet. Durch die Bewegung BW der Spaltblende SB in Richtung der z-Achse kann eine Blendenpositionierung gefunden werden, unter der die Hellfeldbedingung erfüllt wird. Die Längserstreckung der Spalt fläche SF in der Spaltblende ist entsprechend der Notwendigkeit, die Markierungsfläche MF in jedem Zustand ausreichend zu beleuchten, ausgelegt. Über die Minimierung der Blendenöffnung quer zu deren Längserstreckung kann in Anlehnung an den Gegenstand des Anspruches 1 ein optimaler Kontrast am Empfangssensor ES erreicht werden.

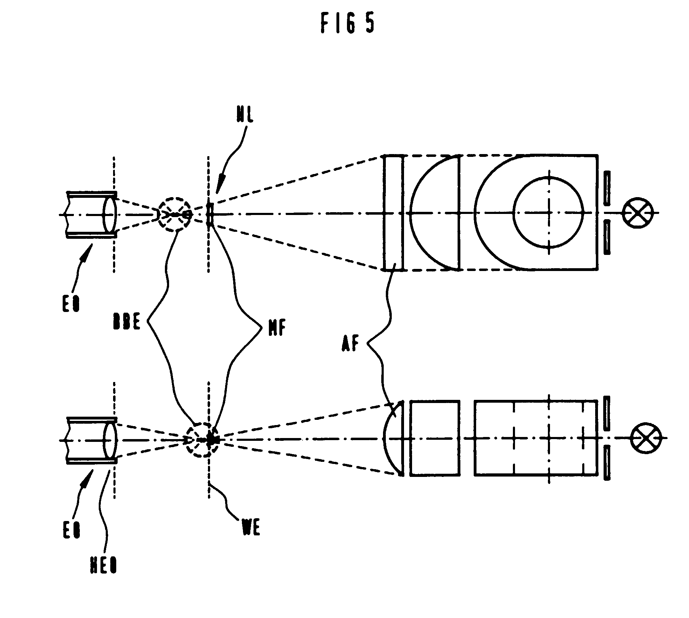

Statt eines Lichtleiters zur Homogenisierung des Lichtes kann auch mit einem speziellen Linsensystem entsprechend Fig. 5 mit gerichtetem Licht eine gleichmäßige Ausleuchtung der Markierungsfläche erzielt werden. Zunächst wird das Licht mit einer Bohrung in einem ersten Linsenelement aufgeweitet. Weitere Zylinderlinsen bündeln in gerichteter Weise das Licht so, daß die Markierungsfläche MF homogen ausgeleuchtet ist. Das reflektierte Licht gelangt dann in die Empfängeroptik EO. Im Bild 5 ist der Strahlengang zum besseren Verständnis geradlinig dargestellt. Bei der Anwendung des Verfahrens wird in der Ebene des Wafers W das Licht reflektiert. Durch die hier verwendeten einfachen Zylinderlinsen ist das Bild des Beleuchtungselementes längs der optischen Achse länglich verzerrt, wodurch bei Abstandsveränderungen des Wafers noch ausreichend homogene Ausleuchtung gegeben ist.

Durch die Dimensionierung der Breite und der Höhe der Beleuchtungslinsen kann die rechteckige Fläche der Markierungsfläche MF mit der Strichcodierung vollständig ausgeleuchtet werden (Fig. 5). Mit dieser Dimensionierung können auch die Anforderungen an das Verfahren, eine spiegelnde Oberfläche zu behandeln bzw. eine Verkippung des Wafers W um die y-Achse entsprechend Fig. 4 mit zu berücksichtigen, erreicht werden. Im Bereich der Austrittsfläche AF kann auch eine bewegliche Spaltblende SB wie in Fig. 4 angeordnet werden. Um einen guten Kontrast zu erzielen, ist auf jeden Fall das Prinzip der Fig. 2a und 2b anzuwenden.

Als Abbildungsoptik werden sphärische Linsen in Kombination mit Zylinderlinsen verwendet. Brennweite und Anordnung sind so gewählt, daß sich unterschiedliche Abbildungsmaßstäbe in x und in z-Richtung ergeben. Eine derartige Optik wird insbesondere deswegen verwendet, weil die Höhe der Strichcodierung verkleinert auf die Höhe der Fotodiodenelemente abgebildet werden soll. Hierdurch wird eine Integration erreicht. Schlieren oder Kratzer auf dem Strichcode haben dadurch nur noch geringen Einfluß auf die jeweilige Helligkeit im Bild bzw. auf den Spannungspegel des elektrischen Signales der Fotodiodenzeile im Empfangssensor ES. Die Markierungselemente werden üblicherweise mittels Laser aufgebracht. Diese meist punktförmigen Vertiefungen haben mehr oder weniger große Abstände zueinander. Auch hier wirkt sich der Integrationseffekt dieser Abbildungsoptik günstig auf das Bild bzw. auf das elektrische Signal aus.

Das Ziel, die Höhe der Strichcodierung integrierend auf die Fotodiodenzeile abzubilden, läßt sich auch ohne eine anamorphotische Abbildungsoptik mit einer speziellen Fotodiodenzeile erreichen. Der Strichcode wird mit einer üblichen sphärischen Optik auf eine spezielle Fotodiodenzeile mit extrem hohen Fotodiodenelementen abgebildet.

Zur Automatisierung wird das Gesamtsystem geregelt. Wie bereits beschrieben, unterliegt die Waferidentifikation den unterschiedlichsten Störgrößen. Diese lassen sich unterteilen in eine Längenänderung der Markierungsfläche MF gegenüber der definierten Soll-Lage und der Rauhigkeitsänderung zwischen den Markierungsflächen MF unterschiedlicher Wafer. Die Störgrößen bewirken eine Kontrastverschlechterung. Eine Identifikation der Markierung kann unmöglich werden. Mit Hilfe der Nachregelung wird der Einfluß dieser Störgrößen reduziert.

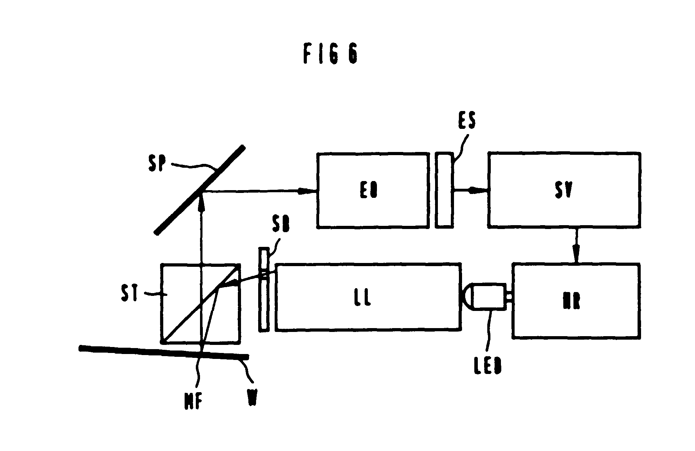

Die Fig. 6 zeigt die Gesamtanordnung zur Durchführung eines erfindungsgemäßen Verfahrens. Die Regelung verwendet folgende Regelgrößen:
a) maximale Helligkeit oder mittlere Gesamthelligkeit S(h) und
b) maximale oder mittlere Nutzsignalhelligkeit S(n).

Diese Regelgrößen werden über eine elektrische Aufbereitung des vom Empfängersensor ES zur Verfügung gestellten Signales in eindeutig den Regelgrößen zuzuordnende elektrische Signale S(h) bzw. S(n) umgeformt.

Die von der Regelung zur Verfügung gestellten Stellgrößen bewirken eine Änderung der an der Austrittsfläche AF abgestrahlten Helligkeit und eine Änderung der Position der Spaltblende SB.

Eine Lageänderung der Markierungsfläche kann durch Verkippung des Wafers W gegenüber einer Soll-Lage oder durch Verbiegung der Waferoberfläche entstehen. Grenzen für Verdrehungen der Markierungsfläche MF um die z-Achse werden über die Höhe der Strichcodierung, für Verdrehungen um die y-Achse über die Breite der Spalt fläche SF quer zu deren Längserstreckung und der leuchtenden Austrittsfläche AF vorgegeben (Fig. 4).

Eine Verkippung der Markierungsfläche MF um die x-Achse sowie eine Variation der Markierungsflächenposition in z-Richtung bewirken eine Änderung des für die Hellfeldabbildung notwendigen Reflexionswinkels. Die Markierung wird nicht mehr optimal beleuchtet und mit schlechtem Kontrast über die Empfängeroptik abgebildet. Eine Anpassung der Beleuchtung wird mit der Positionskorrektur der Spaltblende SB erreicht. Die Spaltblende SB wird durch eine Nachregelung in z-Richtung so verschoben, daß ein maximaler Lichteintritt in den Empfängersensor bzw. in das Empfängersensorfeld entsteht. Das gemessene elektrische Signal S(h) wird über die Stellung der Spaltblende SB auf Maximum geregelt. Fällt während dieses Regelvorganges auf den Empfängersensor ES zuviel Licht, so wird die Intensität des an der Austrittsfläche AF austretenden Lichtes nachgeregelt.

Der Kontrast auf der Waferoberfläche kommt durch unterschiedliche Rauhigkeiten zwischen Markierungselementen ME und diesen umgebende bzw. umliegende Markierungsfläche UM zustande. Die Rauhigkeiten bewirken eine Streuung des von der Markierungsfläche MF reflektierten Lichtes. Die Rauhigkeiten der dem Lesekopf angebotenen Markierungen sind nicht immer gleich. Die auf dem Empfängersensor ES einfallende Lichtmenge ist abhängig von der Markierungsqualität. Mit der Regelung wird die Helligkeit an der Austrittsfläche AF so eingestellt, daß der der Regelgröße entsprechende elektrische Nutzsignalpegel S(n) maximal ist.

In Fig. 5 sind neben der Beleuchtung mit Blende und der entsprechend angepaßten Optik mit einer spezifischen Austrittsfläche AF weiterhin angedeutet die Empfängeroptik EO, die Waferebene WE, die Markierungsfläche MF und die Stelle, an der homogenes Licht HL vorliegt. Die Hauptebene der Abbildungsoptik ist mit HEO bezeichnet. Das Bild des Beleuchtungselementes ist mit BBE gekennzeichnet.

In der Figur 6 ist zusätzlich zu den bisher beschriebenen Elementen eine Signalverarbeitung SV angedeutet, sowie eine Helligkeitsregelung HR.

Die Definition einer Hellfeldbeleuchtung ist insbesondere:

Das Licht der Beleuchtung wird auf der Objektoberfläche reflektiert (Einfallswinkel = Ausfallswinkel). Das reflektierte Licht gelangt direkt in die Empfängeroptik EO. Falls die Objektoberfläche nicht einem idealen Spiegel entspricht, sondern das einfallende Licht durch Rauhigkeit gestreut wird, wird das Lichtbündel aufgeweitet und es fällt nicht mehr das gesamte eingestrahlte Licht in die Empfängeroptik EO.

Als Markierungsfläche wird insbesondere ein Flächenabschnitt auf dem Wafer bzw. auf einer spiegelnden Oberfläche betrachtet, auf welchem mit einem bestimmten Verfahren (Lasermarkierung) stellenweise eine Rauhigkeitsänderung der Fläche herbeigeführt wurde.

Ein Markierungselement ME ist ein in der Markierungsfläche MF vorhandener Flächenausschnitt, dessen Lage vorbestimmt ist. Die Aufrauhung kann durch ein Laserverfahren geschehen. Hierbei werden kleine Löcher in die Fläche eingeschmolzen bzw. eingebrannt. Die vom Laser eingeschmolzenen Markierungspunkte liegen nicht immer bündig nebeneinander. Zwischen den einzelnen Markierungspunkten können auch unveränderte Flächenelemente liegen.

Unter Nutzsignalhelligkeit wird das Signal verstanden, daß durch die Abbildung der Strichcodierung im Empfängersensor bzw. Empfängersensorfeld entsprechend dem Verlauf der Strichcodierung erzeugt wird. Helligkeitsänderungen drücken sich durch elektrische Signalpegeländerungen aus. Die über eine Abtastperiode gemessene mittlere Pegeländerung ist die mittlere Nutzsignalhelligkeit. Die über einen Abtastzeitraum gemessene maximale elektrische Pegeländerung ist die mittlere Pegeländerung. Der gemessenen Nutzsignalhelligkeit ist das eindeutige elektrische Signal S(n) zugeordnet.

Die Elemente von Strichcodierungen (Vertiefungen) bewirken eine Strahlablenkung. Je nach der Tiefe des in den Wafer W eingebrachten Barcodes können Ablenkwinkel von im Mittel 1° oder größer auftreten. Die Blendenöffnung der beweglichen Spaltblende SB ist einem diesbezüglich minimalen Winkel angepaßt, so daß die meisten von einer Strichcodierung reflektierten Lichtstrahlen nicht in die Abbildungsoptik fallen. Das Element der Strichcodierung wird auf dem Empfangssensor ES dunkel abgebildet. Die Helligkeit der Leuchtdioden LED kann anschließend so nachgeregelt werden, daß ein maximaler Kontrast entsteht.

Zur Herstellung eines schichtweise aufgebauten Lichtleiters LL zur Erzeugung einer Lichtzeile kann beispielsweise normales Glas oder Plexiglas bzw. ein anderes gebräuchliches Lichtleitermaterial verwendet werden. Nicht nur die Nachregelung zur Erzielung eines optimalen Kontrastes, sondern auch die Auf- und Abbewegung der Spaltblende SB läßt sich automatisieren. Auf die Fläche der Blende muß homogenisiertes Licht auftreffen. Die Blende schneidet daraus einen bestimmten Teil heraus. Die insgesamt drei Varianten zur Erzeugung einer Lichtzeile bzw. zur Erzeugung homogenisierten, auf die Markierungsfläche MF gerichteten Lichtes sind jede für sich realisierbar.

Der prinzipielle Gedanke der Erfindung besteht darin, einen stark eingeengten Winkelbereich des auf dem Wafer auftreffenden Lichtes zu erfassen und auszuwerten. Um sog. softmarks (Vertiefungen mit ca. 0,5 µm Tiefe) mit ausreichendem Kontrast gegenüber deren Umgebung zu erkennen, sind die beschriebenen Bedingungen notwendig. Die Bedingung für eine Lichtzeile besteht darin, daß je schmaler die Lichtzeile (in z-Richtung gesehen), desto scharfer ist der Kontrast. Mit zunehmender Rauhigkeit der Oberfläche wird die Verteilung des reflektierten Lichtes (Streukeule) breiter und der Kontrast im Verhältnis zur umliegenden Markierungsfläche UM, die weitestgehend spiegelnd reflektiert, wird größer.

Eine Strichcodemarkierung, beispielsweise ein Barcode, hat folgende Daten:

Strichhöhe: 1,7 mm mit insgesamt 18 Markierungspunkten (dots).
Ein Markierungsfeld MF weist die flächige Ausdehnung von ca. 16 x 1,7 mm auf.

Mit der Erfindung können auch Strichcodierungen, die mit hardmarks erzeugt wurden, gelesen werden. Hardmarks sind Markierungspunkte, aus denen die Balken einer Strichmarkierung hergestellt wurden, wobei jeweils tiefere Bohrungen vorliegen.

Wie eingangs beschrieben, bestehen die Probleme bei der Identifizierung von Wafern, deren spiegelnde Oberfläche mit einer Balkencodierung, insbesondere einem Barcode, versehen ist, darin, daß zunächst ein ausreichend kontrastreiches Bild auf einem Empfänger erzeugt werden muß. Erschwerend kommt hinzu, daß die Aufbringung der Markierungen innerhalb einer Balkencodierung neuerdings mit sog. Softmarcs, die eine sehr geringe Tiefe aufweisen, geschieht. Somit liegt eine Störung in einer fehlerfreien Oberfläche vor, die keinesfalls das Licht wie ein tiefes Loch verschluckt, sondern sich im wesentlichen durch eine unterschiedliche Oberflächenrauhigkeit oder auch Oberflächengeometrie (Wölbung) von der fehlerfreien umgebenden Oberfläche unterscheidet.

Anstelle der Hellfeldbeleuchtung kann selbstverständlich eine Dunkelfeldbeleuchtung eingestellt werden. Im Ausführungsbeispiel ist im wesentlichen eine Hellfeldbeleuchtung dargestellt worden. Die Dunkelfeldbeleuchtung wird entsprechend ihrer Definition derart eingestellt, daß die Beleuchtungsstrahlen, die auf die die Markierungselemente ME umgebenden Flächen UM treffen, nicht in die Empfängeroptik EO und damit in den Empfangssensor ES einfallen.

In der Figur 4 ist auf dem Wafer W schematisch eine strukturierte Fläche, die Markierungsfläche MF, dargestellt. Sie enthält die Markierungselemente ME und die zwischenliegenden oder umliegenden Flächen UM, die im wesentlichen die Beschaffenheit der restlichen Waferoberfläche aufweisen.

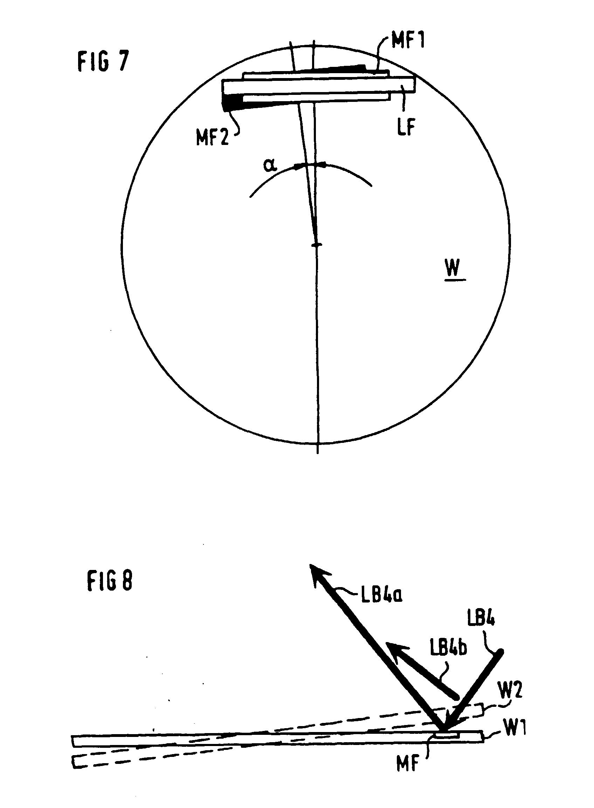

In den Figuren 7 und 8 wird verdeutlicht, wie sich eine Verdrehung oder Verkippung eines Wafers W auswirken kann. Figur 7 zeigt eine Verdrehung des Wafers W um den Winkel a. Das Lesefeld LF erfaßt in dem dargestellten Zustand auf jeden Fall eine lagerichtig ausgerichtete Markierungsfläche MF1 und entsprechend Figur 7 auch noch eine verdrehte Markierungsfläche MF2. Somit ist sichergestellt, daß geringfügige Verdrehungen nicht zu Fehlmessungen führen bzw. die Erkennungssicherheit erhöhen. Auf einem in der Figur 8 lagerichtig dargestellten Wafer W1 mit einer Markierungsfläche MF wird ein einfallendes Lichtbündel LB4 entsprechend dem Reflexionsgesetz als reflektiertes Lichtbündel LB4a reflektiert. Bei einer Verkippung entsprechend dem dargestellten Wafer W2 wird ein reflektiertes Lichtbündel LB4b erzeugt. Die Länge der Pfeile, die in Figur 8 die Lichtbündel darstellen, ist rein schematisch. Die in Figur 8 dargestellte geringfügige Verkippung eines Wafers führt bei einem Lesevorgang entsprechend der Erfindung ebenfalls nicht zu einer Fehlmessung.

## Patentansprüche

1. Verfahren zur Aufnahme von Strichcodierungen, wobei
- die stationäre Strichcodierung mittels einer Beleuchtungseinrichtung ausgeleuchtet wird und eine Empfangsoptik (EO) die Fläche mit der Strichcodierung in deren Längsrichtung, hier in x-Richtung liegend, vollständig und bezogen auf die Höhe der Markierungselemente (ME), die in y-Richtung verlaufen, zumindest teilweise auf einen ein- oder zweidimensional ortsauflösenden Empfänger abbildet,
- Lichtbündel von der Beleuchtungseinrichtung auf die Fläche mit der Strichcodierung derart auftreffen, daß die reflektierten Lichtbündel über eine Empfangsoptik (EO) auf dem Empfangssensor (ES) eine maximale Beleuchtungsstärke als Hellfeldbeleuchtung in bezug auf die die Markierungselemente (ME) umgebenden Flächen (UM) erzeugen,
- eine an der Beleuchtungseinrichtung erzeugte Lichtzeile derart ausgerichtet ist, daß Lichtbündel, die vom Anfang bis zum Ende der Lichtzeile, in Längsrichtung gesehen, ausgehen, auf Flächenelemente vom Anfang bis zum Ende der Fläche mit der Strichcodierung unter Hellfeldbeleuchtung auftreffen und somit die von den die Markierungselemente (ME) umgebenden Flächen (UM) reflektierten Lichtbündel über die Empfängeroptik (EO) in den Empfangssensor (ES) gelangen,
**dadurch gekennzeichnet,**
daß
- die Lichtzeile quer zu ihrer Längserstreckung und quer zu den betrachteten Lichtbündeln bewegt wird, bis diese Hellfeldbeleuchtung vorliegt und bis die Lichtbündel auf die Strichcodierung auftreffen und unter Hellfeldbeleuchtung über die Empfangsoptik (EO) in den Empfangssensor (ES) gelangen, und
- die Breite der Lichtzeile so ausgeführt ist, daß Lichtanteile von auf der Strichcodierung gestreutem Licht, die ihren Ursprung in den Randbereichen der Lichtzeile haben und die in die Empfangsoptik (EO) gelangen, minimiert werden.

2. Verfahren zur Aufnahme von Strichcodierungen, wobei die stationäre Strichcodierung mittels einer Beleuchtungseinrichtung ausgeleuchtet wird und eine Empfangsoptik (EO) die Fläche mit der Strichcodierung in deren Längsrichtung, hier in x-Richtung liegend, vollständig und bezogen auf die Höhe der Markierungselemente (ME), die in y-Richtung verlaufen, zumindest teilweise auf einen ein- oder zweidimensional ortsauflösenden Empfänger abbildet
**dadurch gekennzeichnet,**
daß
- Lichtbündel von der Beleuchtungseinrichtung auf die Fläche mit der Strichcodierung derart auftreffen, daß die reflektierten Lichtbündel über eine Empfangsoptik (EO) auf dem Empfangssensor (ES) eine maximale Beleuchtungsstärke als Dunkelfeldbeleuchtung in bezug auf die die Markierungselemente (ME) umgebenden Flächen (UM) erzeugen,
- eine an der Beleuchtungseinrichtung erzeugte Lichtzeile derart ausgerichtet ist, daß Lichtbündel, die vom Anfang bis zum Ende der Lichtzeile, in Längsrichtung gesehen, ausgehen, auf Flächenelemente vom Anfang bis zum Ende der Fläche mit der Strichcodierung unter Dunkelfeldbeleuchtung auftreffen und somit die von den die Markierungselemente (ME) umgebenden Flächen (UM) reflektierten Lichtbündel nicht in den Empfangssensor (ES) gelangen,
- die Lichtzeile quer zu ihrer Längserstreckung und quer zu den betrachteten Lichtbündeln bewegt wird, bis diese Dunkelfeldbeleuchtung vorliegt, und
- die Breite der Lichtzeile so ausgeführt ist, daß Lichtanteile von auf der Strichcodierung gestreutem Licht, die ihren Ursprung in den Randbereichen der Lichtzeile haben und die in die Empfangsoptik (EO) gelangen, minimiert werden.

3. Verfahren nach Anspruch 1 oder 2,
**dadurch gekennzeichnet,**
daß die Erzeugung einer bewegbaren Lichtzeile durch den Einsatz einer Spaltblende (SB) geschieht, die einer Lichtquelle nachgeschaltet ist, wobei das auf die Spaltblende (SB) fallende Licht homogenisiert ist.

4. Verfahren nach Anspruch 1 oder 2,
**dadurch gekennzeichnet,**
daß die Erzeugung einer bewegbaren Lichtzeile durch den Einsatz mehrerer übereinander liegender Lichtleiter (LL) geschieht, die jeweils einzeln mit Licht beschickbar sind und deren stirnseitige Lichtaustrittsfläche mehrere übereinander liegende Lichtzeilen darstellt, die jeweils homogenes Licht aussenden.

5. Verfahren nach einem der vorhergehenden Ansprüche,
**dadurch gekennzeichnet,**
daß die Empfangsoptik die Länge und die Höhe der Strichcodierung jeweils mit unterschiedlichem Abbildungsmaßstab abbildet, so daß die Länge der Strichcodierung in der Abbildung auf dem Empfangssensor (ES) vollständig und die Höhe der Strichcodierung in der Abbildung auf dem Empfangssensor (ES) teilweise oder vollständig abgebildet wird.

6. Verfahren nach einem der vorhergehenden Ansprüche,
**dadurch gekennzeichnet,**
daß die auf den Empfängersensor (ES) auftreffende Beleuchtungsstärke zur Kontrastoptimierung geregelt wird, wobei die Regelung die Einstellung der Position der bewegbaren Lichtzeile und die Intensität des Lichtes in der Beleuchtungseinrichtung entsprechend nachstellt.

## Claims

1. Method for imaging bar codes,
- the stationary bar code being illuminated by means of an illumination device and receiving optics (EO) imaging the area having the bar code completely in its longitudinal direction, here lying in the x-direction, and at least partially with reference to the height of the marking elements (ME), which run in the y-direction, onto a one- or two-dimensionally spatially resolving receiver,
- bundles of light from the illumination device being incident on the area having the bar code in such a way that the reflected bundles of light generate, via receiving optics (EO), a maximum illumination intensity on the receiving sensor (ES) as bright-field illumination with respect to the areas (UM) surrounding the marking elements (ME),
- a line of light generated on the illumination device being oriented in such a way that bundles of light which proceed from the beginning to the end of the line of light, seen in the longitudinal direction, are incident on area elements from the beginning to the end of the area having the bar code under bright-field illumination, and thus the bundles of light reflected from the areas (UM) surrounding the marking elements (ME) get into the receiving sensor (ES) via the receiver optics (EO), characterized in that
- the line of light is moved transversely to its longitudinal extent and transversely to the bundles of light considered, until said bright-field illumination is present and until the bundles of light are incident on the bar code and get into the receiving sensor (ES) via the receiving optics (EO) under bright-field illumination, and
- the width of the line of light is designed in such a way that light components of light scattered on the bar code, which have their origin in the edge regions of the line of light and get into the receiving optics (EO), are minimized.

2. Method for imaging bar codes, the stationary bar code being illuminated by means of an illumination device and receiving optics (EO) imaging the area having the bar code completely in its longitudinal direction, here lying in the x-direction, and at least partially with reference to the height of the marking elements (ME), which run in the y-direction, onto a one- or two-dimensionally spatially resolving receiver, characterized in that
- bundles of light from the illumination device are incident on the area having the bar code in such a way that the reflected bundles of light generate, via receiving optics (EO), a maximum illumination intensity on the receiving sensor (ES) as dark-field illumination with respect to the areas (UM) surrounding the marking elements (ME),
- a line of light generated on the illumination device is oriented in such a way that bundles of light which proceed from the beginning to the end of the line of light, seen in the longitudinal direction, are incident on area elements from the beginning to the end of the area having the bar code under dark-field illumination, and thus the bundles of light reflected from the areas (UM) surrounding the marking elements (ME) do not get into the receiving sensor (ES),
- the line of light is moved transversely to its longitudinal extent and transversely to the bundles of light considered, until said dark-field illumination is present, and
- the width of the line of light is designed in such a way that light components of light scattered on the bar code, which have their origin in the edge regions of the line of light and get into the receiving optics (EO), are minimized.

3. Method according to Claim 1 or 2, characterized in that the generation of a movable line of light is carried out by using a slit diaphragm (SB) which is connected downstream of a light source, the light incident on the slit diaphragm (SB) being homogenized.

4. Method according to Claim 1 or 2, characterized in that the generation of a movable line of light is carried out by using a plurality of light guides (LL) lying on top of one another, each of which can be individually charged with light and whose light exit face on the end represents a plurality of lines of light on top of one another, each of which emits homogeneous light.

5. Method according to one of the preceding claims, characterized in that the receiving optics image the length and height, respectively, of the bar code with a different imaging scale, so that the length of the bar code is imaged completely in the image on the receiving sensor (ES) and the height of the bar code is imaged partially or completely in the image on the receiving sensor (ES).

6. Method according to one of the preceding claims, characterized in that the illumination intensity incident on the receiver sensor (ES) is controlled to optimize the contrast, the control adjusting the setting of the position of the movable line of light and the intensity of the light in the illumination device accordingly.

## Revendications

1. Procédé d'acquisition de codes à barres, dans lequel
- le code à barres fixe est éclairé au moyen d'un dispositif d'éclairage et un dispositif optique récepteur (EO) reproduit complètement la surface portant le code à barres dans sa direction longitudinale - ici dans la direction x - et, par rapport à la hauteur des éléments de marquage (ME) - qui s'étendent dans la direction y - reproduit cette surface, au moins partiellement, sur un récepteur à résolution locale unidirectionnelle ou bidirectionnelle,
- des faisceaux lumineux arrivent du dispositif d'éclairage sur la surface portant le code à barres, de manière à ce que les faisceaux lumineux réfléchis produisent sur le capteur-récepteur (ES), après être passés dans un dispositif optique récepteur (EO), une intensité d'éclairage maximum en tant qu'éclairage à fond clair par rapport aux surfaces (UM) entourant les éléments de marquage (ME),
- une ligne de lumières produite au niveau du dispositif d'éclairage est orientée de manière à ce que des faisceaux lumineux partant de la ligne de lumières, de son début à sa fin - si on la considère dans le sens longitudinal - arrivent sur des éléments de surface situés du début à la fin de la surface portant le code à barres, en réalisant un éclairage à fond clair, et à ce qu'ainsi, les faisceaux lumineux réfléchis par les surfaces (UM) entourant les éléments de marquage (ME) arrivent dans le capteur-récepteur (ES) en passant dans le dispositif optique récepteur (EO),
caractérisé en ce que
- la ligne de lumières est déplacée perpendiculairement à son étendue longitudinale et perpendiculairement aux faisceaux lumineux considérés jusqu'à ce que l'on obtienne cet éclairage à fond clair et jusqu'à ce que les faisceaux lumineux arrivent sur le code à barres, et arrivent, en réalisant un éclairage à fond clair, dans le capteur-récepteur (ES) en passant dans le dispositif optique récepteur (EO), et
- la largeur de la ligne de lumières est exécutée de manière à ce que les fractions de la lumière dispersée sur le code à barres ayant leur origine dans les zones marginales de la ligne de lumières et arrivant dans le dispositif optique récepteur (EO) soient réduites au minimum.

2. Procédé d'acquisition de codes à barres, dans lequel le code à barres fixe est éclairé au moyen d'un dispositif d'éclairage et un dispositif optique récepteur (EO) reproduit complètement la surface portant le code à barres dans sa direction longitudinale - ici dans la direction x - et, par rapport à la hauteur des éléments de marquage (ME) - qui s'étendent dans la direction y - reproduit cette surface, au moins partiellement, sur un récepteur à résolution locale unidimensionnelle ou bidimensionnelle,
caractérisé en ce que
- des faisceaux lumineux arrivent du dispositif d'éclairage sur la surface portant le code à barres, de manière à ce que les faisceaux lumineux réfléchis produisent sur le capteur-récepteur (ES), après être passés dans un dispositif optique récepteur (EO), une intensité d'éclairage maximum en tant qu'éclairage à fond obscur par rapport aux surfaces (UM) entourant les éléments de marquage (ME),
- une ligne de lumières produite au niveau du dispositif d'éclairage est orientée de manière à ce que des faisceaux lumineux partant de la ligne de lumières, de son début à sa fin - si on la considère dans le sens longitudinal - arrivent sur des éléments de surface situés du début à la fin de la surface portant le code à barres, en réalisant un éclairage à fond obscur, et à ce qu'ainsi, les faisceaux lumineux réfléchis par les surfaces (UM) entourant les éléments de marquage (ME) n'arrivent pas dans le capteur-récepteur (ES),
- la ligne de lumières est déplacée perpendiculairement à son étendue longitudinale et perpendiculairement aux faisceaux lumineux considérés jusqu'à ce que l'on obtienne cet éclairage à fond obscur, et
- la largeur de la ligne de lumières est exécutée de manière à ce que les fractions de la lumière dispersée sur le code à barres ayant leur origine dans les zones marginales de la ligne de lumière et arrivant dans le dispositif optique récepteur (EO) soient réduites au minimum.

3. Procédé selon l'une des revendications 1 ou 2, caractérisé en ce que, pour produire une ligne de lumières mobile, on utilise un diaphragme à fente (SB) qui est installé en aval d'une source lumineuse, la lumière arrivant sur le diaphragme à fente (SB) étant homogénéisée.

4. Procédé selon l'une des revendications 1 ou 2, caractérisé en ce que, pour produire une ligne de lumières mobile, on utilise plusieurs guides de lumière (LL) situés les uns au-dessus des autres, qui peuvent être alimentés en lumière chacun de manière individuelle et dont la face frontale de sortie de la lumière représente plusieurs lignes de lumières situées les unes au-dessus des autres et envoyant chacune de la lumière homogénéisée.

5. Procédé selon l'une des revendications précédentes, caractérisé en ce que le dispositif optique récepteur reproduit la longueur et la hauteur du code à barres à chaque fois avec une échelle de reproduction différente, de manière à ce que la longueur du code à barres soit reproduite complètement dans l'image formée sur le capteur-récepteur (ES) et à ce que la hauteur du code à barres soit reproduite partiellement ou complètement dans l'image formée sur le capteur-récepteur (ES).

6. Procédé selon l'une des revendications précédentes, caractérisé en ce que l'intensité d'éclairage arrivant sur le capteur-récepteur (ES) est réglée en vue de l'optimisation du contraste, le réglage intervenant, de manière correspondante, sur l'ajustement de la position de la ligne de lumières mobile et sur l'intensité de la lumière dans le dispositif d'éclairage.
